# EUROPÄISCHE PATENTSCHRIFT

(11) **EP 3 097 751 B1**
(45) Veröffentlichungstag und Bekanntmachung des Hinweises auf die Patenterteilung: **23.09.2020**
(21) Anmeldenummer: 15701953.0
(22) Anmeldetag: 21.01.2015
(51) Int. Cl.: H05K 7/14, G05B 19/042

(54) **VERBINDUNGSADAPTERSYSTEM DER STEUERUNGSTECHNIK**
CONTROL TECHNOLOGY CONNECTION ADAPTER SYSTEM
SYSTÈME ADAPTATEUR DE COMMUNICATION, POUR LA TECHNIQUE DE COMMANDE

(30) Priorität: 22.01.2014 DE 102014000679
(43) Veröffentlichungstag der Anmeldung: 30.11.2016
(73) Patentinhaber: PHOENIX CONTACT GmbH & Co. KG, 32825 Blomberg (DE)
(72) Erfinder: UTERMÖHLE, Daniel, 37170 Uslar (DE)
(74) Vertreter: Blumbach · Zinngrebe Patentanwälte PartG mbB
(86) Internationale Anmeldenummer: PCT/EP2015/051152
(87) Internationale Veröffentlichungsnummer: WO 2015/110476

(56) Entgegenhaltungen:
- DE-A1-102008 036 967
- DE-A1-102009 047 535
- US-A1- 2005 130 605
- Unknown: "Phoenix Contact - Prozess- und Verfahrenstechnik - Applikationen, Lösungen und Produkte", , 1 April 2012 (2012-04-01), pages 84-95, XP055501714, Germany Retrieved from the Internet: URL:https://www.phoenixcontact.com/assets/ downloads_ed/local_de/web_dwl_promotion/br oschuere_prozess_verfahrenstechnik_de.pdf [retrieved on 2018-08-23]

## Beschreibung

Die Erfindung betrifft ein Verbindungsadaptersystem der Steuerungstechnik zur Übertragung digitaler und/oder analoger Signale zwischen einer Ein-/Ausgabeeinheit einer Steuerungseinrichtung und wenigstens einer Feldkomponente.

Im Sinne der Erfindung wird unter Steuerungstechnik die Automatisierung und Steuerung von industriellen Anlagen über speicherprogrammierbare Steuerungen (SPS) verstanden. Die Ein-/Ausgabeeinheiten bzw. -baugruppen sind dabei beispielsweise Signalbaugruppen einer speicherprogrammierbaren Steuerung, wobei die Signalbaugruppe eine Schnittstelle zu dem industriellen zu automatisierenden Prozess und insbesondere zu den am Prozess beteiligten Feldkomponenten bzw. Feldgeräten bildet.

Die Ein-/Ausgabebaugruppen (E/A-Baugruppen), welche als Signalbaugruppen ausgestaltet sind, können in Digital- und Analogbaugruppen unterschieden werden. Diese wiederum unterscheiden sich z.B. hinsichtlich Kanalzahl, Eingabe oder Ausgabe, Messart und Messbereich, Potentialtrennung, Diagnose- und/oder Alarmfähigkeit.

Für jede SPS stellen die jeweiligen Hersteller dem Anwender Anbindungsmöglichkeiten zur Verfügung, um die SPS mit dem Feld zu verbinden. Ein Anschluss von Feldgeräten, wie Aktoren oder Sensoren, aus dem zu automatisierenden Prozess erfolgt üblicherweise über Signalleitungen und einen sogenannten Frontstecker oder Frontadapter. Der Frontadapter ist geometrisch sowie hinsichtlich der Kanalzahl auf die E/A-Baugruppe abgestimmt und besteht in der Regel aus einem gespritzten Kunststoffkörper, an dem die Signalleitungen der Feldkomponenten zum Beispiel mittels Schraub-, Crimp- oder Zugfedertechnologie angeschlagen sind. E/A-Baugruppe und Frontadapter arbeiten hierbei nach dem Stecker-/Buchse-Prinzip zusammen. Die Leitungslänge der angeschlagenen Signalleitungen orientiert sich nach der Entfernung zu den Feldkomponenten und deren Feldanschlusspunkten. Bekannt sind ferner Frontadapterlösungen, bei denen die Signalleitungen an ihrem anderen Ende mit einem genormten Steckverbinder ausgestattet sind, welcher dann auf ein Feldübergabemodul aufgelegt werden kann, an welches die Feldgeräte angeschlossen sind.

Beim Austausch einer Ein-/Ausgabebaugruppe kann der Frontstecker von der zu tauschenden E/A-Baugruppe abgenommen werden, dabei bleibt die Verdrahtung der Signalleitungen an dem Frontstecker bestehen. Solch ein Austausch einer Baugruppe ist beispielhaft erforderlich, wenn eine alte Baugruppe defekt ist und gegen eine neue funktionstüchtige Baugruppe getauscht werden muss.

Bei einem Baugruppenaustausch kann es jedoch vorkommen, dass die Frontstecker verwechselt werden oder versehentlich eine auszutauschende Baugruppe herangezogen wird, die nicht mit der zuvor vorherrschenden Verschaltungsvorgabe übereinstimmt. Werden die Frontstecker bei einem Baugruppentausch verwechselt, so kann dies zu einer Fehlinterpretation der Prozesssignale bzw. -daten führen. Um dies zu verhindern, ist eine Verwechslung der Frontstecker auszuschließen.

Diesbezüglich sind aus der EP 2 549 843 A1 eine Ein-/Ausgabebaugruppe und ein Frontstecker bekannt, wobei in der Ein-/Ausgabebaugruppe eine erste Schreib-/Leseeinheit und in dem Frontstecker eine zweite Schreib-/Leseeinheit angeordnet ist und wobei die erste Schreib-/Leseeinheit ausgestaltet ist, eine individuelle Zeichenfolge in die zweite Schreib-/Leseeinheit drahtlos zu übertragen, wodurch eine eindeutige Zuordnung zwischen der Ein-/Ausgabebaugruppe und dem Frontstecker sichergestellt werden kann. Die Prozesssignale werden hingegen drahtgebunden zwischen der E/A-Baugruppe und den Feldkomponenten über den Frontstecker und Signalleitungen übertragen oder auch rangiert.

Die Verdrahtung der beteiligten Geräte gestaltet sich unter Umständen aber schwierig, wenn zum Beispiel größere Entfernungen oder Hindernisse zu überwinden sind. Auch ist eine vorhandene Verdrahtung nur schwer änderbar, wenn sie einmal installiert ist. Die Verdrahtung der beteiligten Geräte kann somit aufwändig, unflexibel und teuer sein. Darüber hinaus steigt gerade bei großen Leitungslängen der Widerstand in der Leitung an, was zu einem Spannungsabfall in der Leitung führt. Analoge Signale können dadurch verfälscht werden. Zudem kann es bei beweglichen Elementen im Feld aufgrund der Bewegungen zu Kabelbrüchen kommen. Beides kann zu Ausfällen von Feldkomponenten führen. Sollen aber auch Prozesssignale, welche zum Beispiel Messwerte oder Steuerbefehle darstellen können, drahtlos übertragen werden, sind hierfür zusätzliche Geräte erforderlich, über die die Signale zusätzlich rangiert werden müssen, wodurch der Einrichtungsaufwand zusätzlich erhöht wird.

Beispielsweise zeigen die DE 102008036967 A1 und die US 2005/0130605 A1 Lösungen im Bereich der Steuerungstechnik zur drahtlosen Übertragung von Signalen zwischen Feldgeräten und einer Steuerung. Die DE 102008036967 A1 offenbart ein Verbindungsadaptersystem gemäß dem Oberbegriff des Anspruchs 1.

Eine der Erfindung zugrunde liegende Aufgabe besteht somit darin, eine einfache Möglichkeit zur drahtlosen Übertragung von Signalen in der Steuerungstechnik und zur drahtlosen Übertragung von Signalen zwischen einer Ein- und/oder Ausgabeeinheit einer Steuerungseinrichtung und wenigstens einer Feldkomponente anzugeben.

Erfindungsgemäß wird diese Aufgabe gelöst durch ein Verbindungsadaptersystem mit den Merkmalen nach Anspruch 1. Zweckmäßige Weiterbildungen sind Gegenstand der Unteransprüche.

Das erfindungsgemäße Verbindungsadaptersystem der Steuerungstechnik bietet viele Vorteile. Es ist ausgebildet zur Übertragung digitaler und/oder analoger Signale zwischen wenigstens einer Ein- und/oder Ausgabeeinheit einer Steuerungseinrichtung und wenigstens einer Feldkomponente und dadurch gekennzeichnet, dass wenigstens ein Verbindungsadapter zur drahtlosen Übertragung digitaler und/oder analoger Signale umfasst ist, welcher eine Signalschnittstelleneinheit, eine Kommunikationseinheit und eine Antenneneinheit aufweist, wobei der Verbindungsadapter mittels der Signalschnittstelleneinheit mit der Ein- und/oder Ausgabeeinheit oder mit der Feldkomponente signalleitend kontaktierbar ist und ausgebildet ist, mit Hilfe der Kommunikationseinheit über die Signalschnittstelleneinheit eingehende Signale über die Antenneneinheit weiterzugeben und/oder über die Antenneneinheit eingehende Signale über die Signalschnittstelleneinheit weiterzugeben.

Der Aufwand für das Verlegen von Leitungen zur Signalübertragung kann dadurch reduziert werden oder sogar entfallen.

Vorteilhafter Weise ist die Signalschnittstelleneinheit derart ausgestaltet, dass sie direkt mit der Ein- und/oder Ausgabeeinheit oder mit der Feldkomponente signalleitend kontaktierbar ist, so dass der Einrichtungsaufwand für das Rangieren der Signale gering bleibt oder sogar weiter verringert wird. Darüber hinaus ist durch die drahtlose Signalübertragung eine galvanische Trennung der Ein- und/oder Ausgabeeinheit von den Feldkomponente erreichbar, was in spezifischen Anwendungsfällen einen weiteren Vorteil darstellen kann.

Gemäß einem Aspekt der Erfindung ist der Verbindungsadapter als Frontadapter und die Signalschnittstelleneinheit als Steckverbinder zur Kontaktierung der Ein- und/oder Ausgabeeinheit ausgebildet. Dies bietet den Vorteil, dass der Verbindungsadapter anstelle eines herkömmlichen Frontadapters einfach an die Ein- und/oder Ausgabeeinheit der Steuerungseinrichtung ansteckbar ist, wobei insbesondere weder an der Ein- und/oder Ausgabeeinheit noch an der Steuerungseinrichtung Anpassungen erforderlich sind. Somit ist das Verbindungsadaptersystem auch zur Nachrüstung einer drahtlosen Signalübertragung geeignet.

Gemäß einem weiteren Aspekt der Erfindung ist der Verbindungsadapter als Feldadapter und die Signalschnittstelleneinheit als Steckverbinder oder als Anschlussblock für Signalleitungen zur Kontaktierung der wenigstens einen Feldkomponente ausgebildet. Dies bietet den Vorteil, dass der Verbindungsadapter einfach an die jeweilige Feldkomponente ansteckbar bzw. mit dieser verbindbar ist. Bei der Feldkomponente kann es sich um ein Feldgerät, wie einen Sensor oder Aktor oder auch um ein Feldübergabemodul, an welches wiederum wenigstens ein Feldgerät angeschlossen ist, handeln. Der Anschlussblock kann zum Beispiel Schraub-, Federzug- oder Schneid-/Klemmanschlüsse für die Signalleitungen der Feldkomponenten aufweisen.

Gemäß einem weiteren Aspekt der Erfindung umfasst das Verbindungsadaptersystem zwei Verbindungsadapter, von denen der eine als Frontadapter und der andere als Feldadapter, wie zuvor beschrieben, ausgebildet ist. Dann können über die Signalschnittstelleneinheit des einen Verbindungsadapters eingehende Signale über die Antenneneinheit des einen Verbindungsadapters drahtlos an die Antenneneinheit des anderen Schnittstellenadapters weitergegeben und über die Signalschnittstelleneinheit des anderen Verbindungsadapters ausgegeben werden und/oder umgekehrt.

Gemäß einem weiteren Aspekt der Erfindung weist der Verbindungsadapter eine Versorgungsspannungsschnittstelleneinheit auf, über welche der Verbindungsadapter eine Versorgungsspannung beziehen kann. Dabei ist es je nach Ausführung möglich, dass der Verbindungsadapter die nötige Versorgungsspannung über entsprechende Versorgungsleitungen von der Ein- und/oder Ausgabeeinheit oder von der Feldkomponente erhält, wobei die Versorgungsspannungsschnittstelleneinheit als Teil der Signalschnittstelleneinheit ausgebildet sein kann und mit dieser eine gemeinsame Schnittstelle, insbesondere in Form eines gemeinsamen Steckverbinders, bildet, so dass vorteilhafter Weise mit nur einem Steckvorgang sowohl die Signalleitungen als auch die Versorgungsleitungen zwischen dem Verbindungsadapter und der Ein- und/oder Ausgabeeinheit bzw. der Feldkomponente kontaktiert sind. Ergänzend oder alternativ kann in einer anderen Ausführungsform vorgesehen sein, dass über die Versorgungsspannungsschnittstelleneinheit die nötige Versorgungsspannung über entsprechende Versorgungsleitungen aus einer separaten bzw. zusätzlichen Spannungsquelle bezogen wird. Somit ist der Verbindungsadapter auch an solchen Ein-/Ausgabeeinheiten oder Feldkomponenten betreibbar, die selbst keine Versorgungsspannung bereitstellen können.

Gemäß einem weiteren Aspekt der Erfindung weist der Verbindungsadapter eine Konfigurationseinheit auf, mittels welcher der Verbindungsadapter konfigurierbar ist und zwar insbesondere hinsichtlich der Art der Signale (digital oder analog), der Richtung der Signale (Eingang oder Ausgang) und/oder der Rangierung der Signale. Solche und zweckmäßiger Weise noch weitere Parameter sind bevorzugt für jede vorhandene Signalleitung separat konfigurierbar. Die Konfigurationseinheit kann dazu eine Bedienschnittstelle bereitstellen, welche zum Beispiel einen oder mehrere DIP-Schalter aufweist, die den jeweiligen Parametern zugeordnet sind. In einer anderen Ausführungsform kann die Konfigurationseinheit ausgebildet sein, drahtlos (zum Beispiel per NFC/RFID, Bluetooth oder WLAN/WiFi) mit einem mobilen Gerät wie zum Beispiel einem Smartphone oder Tabletcomputer zu kommunizieren, um eine Bedienschnittstelle an dem mobilen Gerät bereitzustellen und an dem mobilen Gerät vorgenommene Konfigurationseinstellungen zu empfangen und entsprechend umzusetzen. Die Konfigurationseinheit kann ferner einen Speicher umfassen, in welchen die Konfigurationseinstellungen speicherbar sind. Hinsichtlich der Rangierung der Signale lässt sich beispielsweise konfigurieren, welches über die Antenneneinheit eingegangene Signal über welche Signalleitung der Signalschnittstelleneinheit weitergegeben werden soll. Dank der Konfigurationseinheit ist der Verbindungsadapter universell und vielseitig einsetzbar und dabei an die jeweils vorliegenden Bedingungen spezifisch anpassbar.

Erfindungsgemäß ist vorgesehen, dass mittels der Konfigurationseinheit eine Adressierungs- bzw. Identifizierungsinformation für den Verbindungsadapter und/oder für wenigstens eine Feldkomponente, die an den Verbindungsadapter angeschossen ist, konfigurierbar ist. Anhand der Identifizierungsinformation, z.B. einer eindeutigen Kennung, kann ein bestimmter Verbindungsadapter erkannt und dadurch einer Verwechslung mit einem anderen Verbindungsadapter vorgebeugt werden. Für einzelne an den Verbindungsadapter angeschlossene Feldkomponenten kann eine jeweilige Adressierungs- bzw. Identifizierungsinformation konfiguriert werden, indem sie zum Beispiel der jeweiligen Signalleitung der Feldkomponente zugeordnet wird. Die Kommunikationseinheit des Verbindungsadapters ist weiter dazu ausgebildet bestimmte Signale, die über eine mit einer Identifizierungsinformation versehenen Signalleitung an der Signalschnittstelleneinheit eingehen, um diese Identifizierungsinformation zu ergänzen.

Diese sowie weitere Merkmale und Vorteile ergeben sich auch aus der folgenden Beschreibung von Ausführungsbeispielen in Zusammenhang mit den beiliegenden Zeichnungen. Es zeigt
- Figur 1: eine schematische Darstellung eines Verbindungsadaptersystems gemäß Stand der Technik;
- Figur 2: eine schematische Darstellung eines weiteren Verbindungsadaptersystems gemäß Stand der Technik;
- Figur 3: eine schematische Darstellung eines Verbindungsadaptersystems in einer erfindungsgemäßen Ausführungsform; und
- Figur 4: eine schematische Darstellung eines Verbindungsadaptersystems in einer weiteren erfindungsgemäßen Ausführungsform.

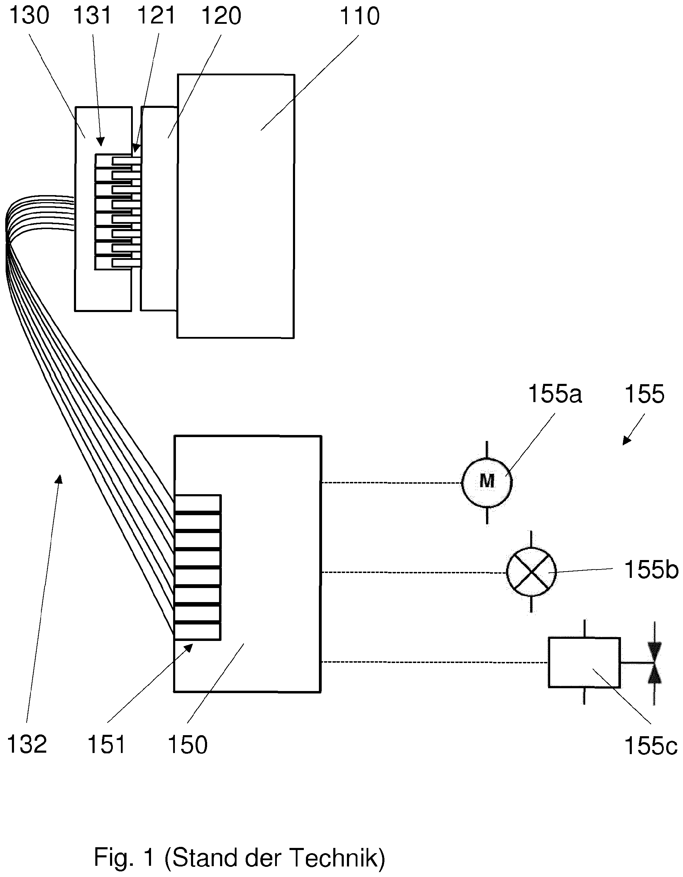

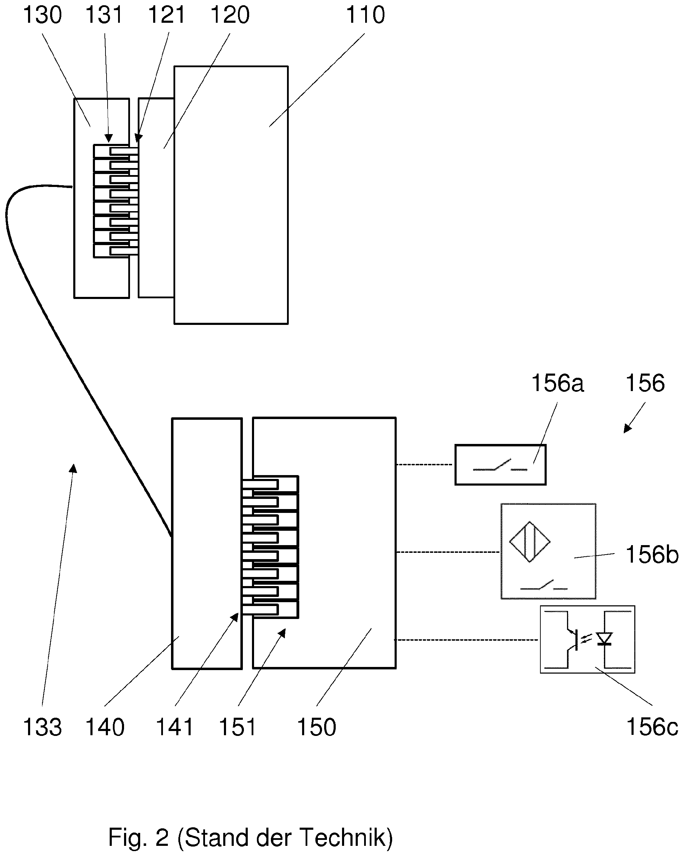

Die Figuren 1 und 2 zeigen beispielhaft Verbindungsadaptersysteme gemäß Stand der Technik wie eingangs bereits beschrieben.

Zunächst ist in der Figur 1 eine Steuerungseinrichtung (SPS) 110 zu sehen, der eine Ein-/Ausgabebaugruppe (E/A-Baugruppe) 120 zugeordnet ist, die Teil der SPS 110 ist oder zumindest mit dieser in Kommunikationsverbindung steht, zum Beispiel über einen Kommunikationsbus, welcher hier nicht gezeigt ist. Die E/A-Baugruppe 120 weist eine Signalschnittstelle in Form einer Reihe von Kontaktstiften 121 auf, über welche Signale und insbesondere Prozesssignale wie Messwerte und Steuerbefehle oder auch Diagnose- oder Alarmsignale empfangen und ausgegeben werden können. Steuerbefehle können dabei für Feldgeräte 155 bestimmt sein, die insbesondere als Aktoren den Prozess beeinflussen und beispielsweise als Motor 155a, als Leuchtmelder 155b oder als Magnetventil 155c ausgebildet sind. Messwerte können ferner von Feldgeräten 156 stammen (vgl. Figur 2), die insbesondere als Sensoren Parameter des Prozesses erfassen und beispielsweise als Kontaktschalter 156a, als induktiver Näherungsschalter 156b oder als Lichtschranke 156c ausgebildet sind.

Damit derartige Signale zwischen der E/A-Baugruppe 120 und den Feldgeräten 155, 156 übertragbar sind, sind zu deren Verbindung gemäß Figur 1 ein Feldübergabemodul 150 als weitere Feldkomponente und ein Frontstecker 130 mit mehreren Signalleitungen 132 vorgesehen. Der Frontstecker 130 ist als Steckverbinder ausgebildet und verfügt über eine Signalschnittstelle in Form einer Reihe von Kontaktbuchsen 131 passend zu der Reihe von Kontaktstiften 121 der E/A-Baugruppe, wobei der Frontstecker an die E/A-Baugruppe angesteckt ist. Jede der an den Frontstecker angeschlagenen Signalleitungen 132 führt auf eine der Kontaktbuchsen 131. Mit ihrem anderen Ende sind die Signalleitungen 132 an eine als Klemmblock ausgebildete Signalschnittstelle des Feldübergabemoduls 150 angeschlossen, wobei der Klemmblock eine entsprechende Anzahl an Klemmkontakten 151 aufweist. Das Feldübergabemodul 150 ist ferner mit den einzelnen Feldgeräten 155 verbunden, wobei diese Verbindungen als gestrichelte Linien ohne Bezugszeichen dargestellt sind. Alternativ und in Figur 1 nicht dargestellt könnten die Signalleitungen 132 ohne Zwischenschaltung des Feldübergabemoduls 150 direkt mit den Feldgeräten 155 verbunden sein. Der Einsatz eines Feldübergabemoduls vereinfacht jedoch die Verdrahtung.

In der Figur 2 ist eine weitere Möglichkeit der Verbindung der E/A-Baugruppe 120 mit den Feldgeräten 156 gemäß Stand der Technik dargestellt. Im Unterschied zu Figur 1 sind die an den Frontstecker 130 angeschlagenen Signalleitungen zu einem Kabel 133 zusammengefasst und die von dem Frontstecker 130 entfernten Enden der Signalleitungen sind nicht direkt einzeln an die Signalschnittstelle des Feldübergabemoduls 150 angeschlossen, sondern zunächst an einen Steckverbinder 140 angeschlagen, welcher dann einfach an das Feldübergabemodul 150 angesteckt ist. Der Steckverbinder 140 weist dazu eine Signalschnittstelle in Form einer Reihe von Kontaktstiften 141 passend zu der Reihe von Kontaktbuchsen 151 der Signalschnittstelle des Feldübergabemoduls 150 auf. Das Feldübergabemodul 150 ist wiederum mit den einzelnen Feldgeräten 156 verbunden, wobei diese Verbindungen als gestrichelte Linien ohne Bezugszeichen dargestellt sind.

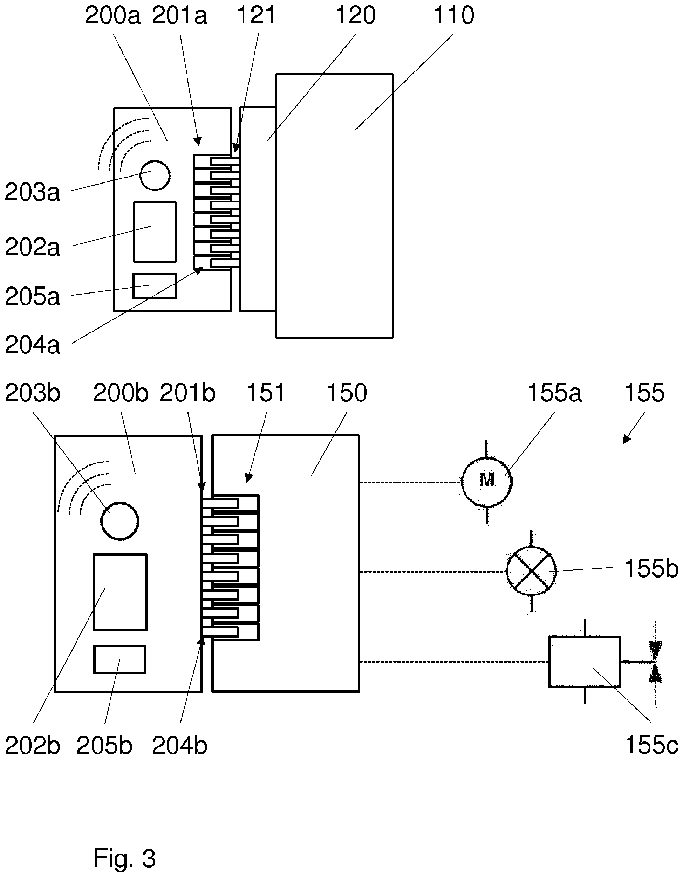

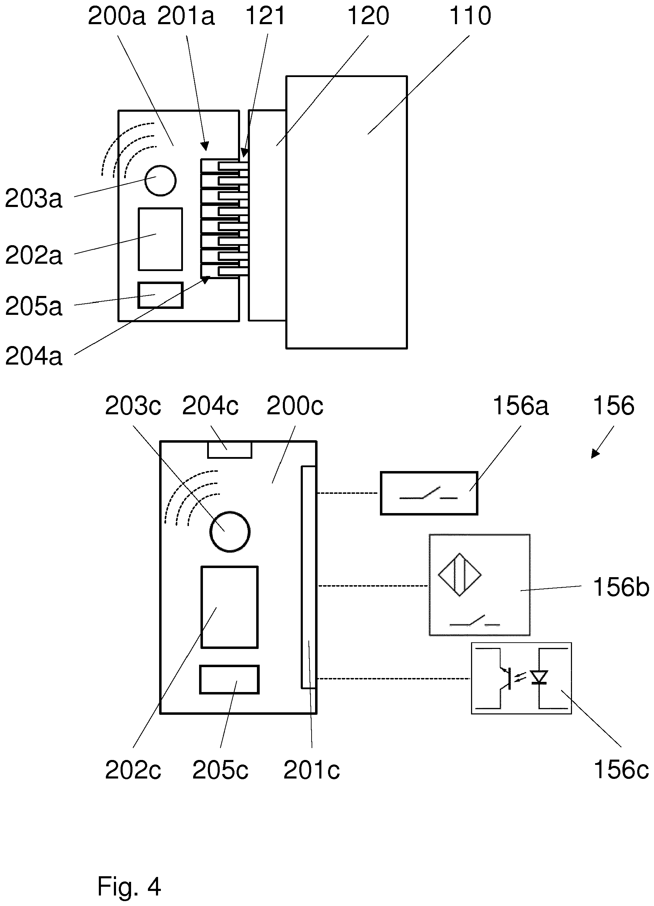

Die Figuren 3 und 4 zeigen Ausführungsformen erfindungsgemäßer Verbindungsadaptersysteme, wobei aus Gründen der Einfachheit und besseren Nachvollziehbarkeit gleiche Bezugszeichen für Komponenten oder Einrichtungen verwendet werden, die gegenüber dem in den Figuren 1 und 2 gezeigten Stand der Technik unverändert sind bzw. bleiben können.

Um eine drahtlose Übertragung von Signalen zwischen einer Ein- und/oder Ausgabeeinheit 120 einer Steuerungseinrichtung 110 und wenigstens einer Feldkomponente 150, 155, 156 zu ermöglichen, ist erfindungsgemäß ein Verbindungsadaptersystem vorgesehen, welches wenigstens einen Verbindungsadapter 200a, 200b bzw. 200c zur drahtlosen Übertragung digitaler und/oder analoger Signale umfasst, der eine Signalschnittstelleneinheit 201a, 201b bzw. 201c, eine Kommunikationseinheit 202a, 202b bzw. 202c und eine Antenneneinheit 203a, 203b bzw. 203c aufweist.

In dem Ausführungsbeispiel gemäß Figur 3 ist anstelle des Frontsteckers 130 (vgl. Figuren 1 und 2) der Verbindungsadapter 200a vorgesehen, der mittels seiner Signalschnittstelleneinheit 201a mit der Ein- und/oder Ausgabeeinheit 120 signalleitend kontaktiert ist. Ferner ist zweckmäßig anstelle des Steckverbinders 140 (vgl. Figur 2) der Verbindungsadapter 200b vorgesehen, der mittels seiner Signalschnittstelleneinheit 201b mit dem Feldübergabemodul 150 (Feldkomponente) signalleitend kontaktiert ist.

Beide Verbindungsadapter 200a und 200b sind ausgebildet, mit Hilfe ihrer Kommunikationseinheit 202a bzw. 202b über die Signalschnittstelleneinheit eingehende Signale über ihre Antenneneinheit 203a bzw. 203b weiterzugeben und/oder über ihre Antenneneinheit eingehende Signale über ihre Signalschnittstelleneinheit weiterzugeben.

Die Signalleitungen 132 bzw. 133 (vgl. Figuren 1 und 2) können daher entfallen, da die Signale nun drahtlos zwischen den Verbindungsadaptern 200a und 200b und insbesondere zwischen deren Antenneneinheiten 203a und 203b übertragen werden können. Die drahtlose Signalübertragung erfolgt dabei bevorzugt mittels eines Funkübertragungsstandards bzw. -protokolls wie Bluetooth, ZigBee oder WLAN/WiFi, je nach zu überbrückender Entfernung zwischen den Verbindungsadaptern 202a und 202b. Dabei sind die Kommunikationseinheiten 202a und 202b bevorzugt ausgebildet, die Signale vor oder bei der Weiterleitung von der Signalschnittstelleneinheit zur Antenneneinheit in das jeweilige Protokoll umzusetzen bzw. umzuwandeln, insbesondere ohne dabei den Informationsgehalt der Signale zu verändern. Zweckmäßiger Weise sind die Kommunikationseinheiten zur Umsetzung bzw. Umwandlung auch in umgekehrter Richtung ausgebildet, also von der Antenneneinheit zur Signalschnittstelleneinheit. Die Kommunikationseinheiten 202a und 202b fungieren somit bevorzugt als Sende- und Empfangseinheiten sowie als Gatewayeinheiten. Die drahtlose Signalübertragung ist dadurch für die Steuerungseinrichtung 110 und die Feldkomponenten 150, 155, 156 transparent.

Wie bereits erwähnt, ersetzt der Verbindungsadapter 200a einen Frontstecker (vgl. Frontstecker 130 in Figuren 1 und 2), und der Verbindungsadapter 200b ersetzt einen Steckverbinder (vgl. Steckverbinder 140 in Figur 2). Dies ist möglich, da gemäß einem besonders vorteilhaften Aspekt der Erfindung der Verbindungsadapter 200a als Frontadapter und dessen Signalschnittstelleneinheit 201a als Steckverbinder zur direkten Kontaktierung der Ein- und/oder Ausgabeeinheit 120 ausgebildet ist, wobei die Signalschnittstelleneinheit eine Reihe von Kontaktbuchsen passend zu der Reihe von Kontaktstiften 121 der Ein- und/oder Ausgabeeinheit 120 aufweist. Auf diese Weise sind weder an der Ein- und/oder Ausgabeeinheit 120 noch an der Steuerungseinrichtung 110 Anpassungen erforderlich. Ferner ist gemäß einem besonders vorteilhaften Aspekt der Erfindung der Verbindungsadapter 202b als Feldadapter und dessen Signalschnittstelleneinheit 201b als Steckverbinder zur direkten Kontaktierung der Feldkomponente, hier des Feldübergabemoduls 150, ausgebildet, wobei die Signalschnittstelleneinheit 201b eine Reihe von Kontaktstiften passend zu der Reihe von Kontaktbuchsen 151 der Signalschnittstelle des Feldübergabemoduls 150 aufweist. Dies bietet den Vorteil, dass der Verbindungsadapter 200b einfach an die Feldkomponente 150 ansteckbar bzw. mit dieser verbindbar ist, ohne das Anpassungen letzterer erforderlich sind. Somit ist das erfindungsgemäße Verbindungsadaptersystem auch zur einfachen Nachrüstung einer drahtlosen Signalübertragung bei einer bereits bestehenden Prozesssteuerung geeignet.

In dem in Figur 4 gezeigten Ausführungsbeispiel umfasst das erfindungsgemäße Verbindungsadaptersystem im Unterschied zu Figur 3 statt des Verbindungsadapters 200b den Verbindungsadapter 202c, welcher jedoch im Wesentlichen dem Verbindungsadapter 200b sehr ähnelt und ebenfalls als Feldadapter ausgebildet ist. Allerdings ist hier die Signalschnittstelleneinheit 201c für das Anschließen bzw. Kontaktieren von Feldgeräten, ohne Zwischenschalten eines Feldübergabemoduls, und insbesondere als Anschlussblock mit Schraub-, Federzug- oder Schneid-/Klemmanschlüssen für die Signalleitungen der Feldgeräte ausgebildet. Die Verbindungen der Feldgeräte mit dem Verbindungsadapter 202c sind als gestrichelte Linien ohne Bezugszeichen dargestellt. Bei den Feldgeräten kann es sich um Sensoren 156 und/oder um Aktoren 155 (vgl. Figur 3) handeln. Der Verbindungsadapter 200c ersetzt somit auch das Feldübergabemodul 150, so dass ein solches hier nicht mehr erforderlich ist.

Die in den Figuren 3 und 4 gezeigten Verbindungsadapter 200a, 200b und 200c verfügen zweckmäßig ferner jeweils über eine Versorgungsspannungsschnittstelleneinheit 204a, 204b bzw. 204c, über welche sie ihre Versorgungsspannung beziehen. Dabei ist die Versorgungsspannungseinheit 204a bzw. 204b als Teil der Signalschnittstelleneinheit 201a bzw. 201b ausgebildet, so dass die Versorgungsspannung von der Ein- und/oder Ausgabeeinheit 120 bzw. von dem Feldübergabemodul 150 bezogen werden kann. Bei dem Verbindungsadapter 200c ist die Versorgungsspannungsschnittstelleneinheit 204c separat ausgebildet, so dass hier eine separate Spannungsquelle (nicht dargestellt) angeschlossen werden kann, welche die nötige Energie für den Betrieb des Verbindungsadapters 200c bereitstellt.

Die Antenneneinheiten 203a, 203b und 203c der in den Figuren 3 und 4 gezeigten Verbindungsadapter 200a, 200b und 200c können vollständig intern, also innerhalb des Adaptergehäuses, oder auch teilweise extern ausgebildet sein, so dass zum Beispiel eine zur Antenneneinheit gehörende Antenne zumindest teilweise aus dem Adaptergehäuse des Verbindungsadapters herausragt. Ferner kann eine zur Antenneneinheit gehörende Antenne zumindest teilweise abtrennbar und austauschbar ausgebildet sein.

Des Weiteren verfügen die in den Figuren 3 und 4 gezeigten Verbindungsadapter 200a, 200b und 200c jeweils über eine Konfigurationseinheit 205a, 205b bzw. 205c, mittels welcher sie konfigurierbar sind. Die Konfigurierbarkeit betrifft dabei insbesondere die Art der Signale (digital oder analog), die Richtung der Signale (Eingang oder Ausgang) und/oder die Rangierung der Signale. Hinsichtlich der Rangierung der Signale lässt sich beispielsweise konfigurieren, welches über die Antenneneinheit eingegangene Signal über welche Signalleitung der Signalschnittstelleneinheit des jeweiligen Verbindungsadapters weitergegeben werden soll. Die Konfigurationseinheit 205a, 205b bzw. 205c kann dazu eine Bedienschnittstelle (nicht dargestellt) bereitstellen, welche zum Beispiel einen oder mehrere DIP-Schalter aufweist, die den jeweiligen Parametern zugeordnet sind. Alternativ kann die Konfigurationseinheit 205a, 205b bzw. 205c jeweils ausgebildet sein, drahtlos mit einem mobilen Gerät (nicht dargestellt) wie zum Beispiel einem Smartphone oder Tabletcomputer zu kommunizieren, um eine Bedienschnittstelle an dem mobilen Gerät bereitzustellen und an dem mobilen Gerät vorgenommene Konfigurationseinstellungen zu empfangen und entsprechend umzusetzen. Zweckmäßiger Weise kann die Konfigurationseinheit 205a, 205b bzw. 205c dabei ferner jeweils einen Speicher (nicht dargestellt) umfassen, in welchen die Konfigurationseinstellungen speicherbar dann sind. Darüber hinaus kann vorgesehen sein, dass als wenigstens ein weiterer Parameter mittels der Konfigurationseinheit 205a, 205b bzw. 205c eine Adressierungs- bzw. Identifizierungsinformation für den jeweiligen Verbindungsadapter 202a, 200b bzw. 200c und/oder für wenigstens eine Feldkomponente 150, 155, 156, die an den Verbindungsadapter 200b bzw. 200c angeschlossen ist, konfigurierbar ist.

In den in den Figuren 3 und 4 gezeigten zweckmäßigen Ausführungsbeispielen umfasst das Verbindungsadaptersystem zwei erfindungsgemäße Verbindungsadapter, von denen der eine als Frontadapter 200a und der andere als Feldadapter 200b, 200c, wie zuvor beschrieben, ausgebildet ist. Dadurch können über die Signalschnittstelleneinheit des einen Verbindungsadapters eingehende Signale über die Antenneneinheit des einen Verbindungsadapters drahtlos an die Antenneneinheit des anderen Schnittstellenadapters weitergegeben und über die Signalschnittstelleneinheit des anderen Verbindungsadapters ausgegeben werden und/oder umgekehrt.

Gemäß einem weiteren Ausführungsbeispiel, welches in den Figuren nicht dargestellt ist, kann das Verbindungsadaptersystem auch nur einen erfindungsgemäßen Verbindungsadapter, zum Beispiel einen Frontadapter, umfassen, welcher dann mit einer herkömmlichen Einrichtung zur drahtlosen Signalübertragung zusammenwirkt, die zum Beispiel einer Feldkomponente zugeordnet ist.

Gemäß einem weiteren Ausführungsbeispiel, welches in den Figuren nicht dargestellt ist, kann das Verbindungsadaptersystem aber auch mehr als zwei erfindungsgemäße Verbindungsadapter umfassen. Zum Beispiel können einem erfindungsgemäßen Frontadapter auch mehrere erfindungsgemäße Feldadapter zugeordnet sein, so dass Signale drahtlos zwischen einer Steuerungseinrichtung bzw. deren Eingabe-/Ausgabeeinheit und zahlreichen Feldkomponenten, die an mehrere Feldadapter angeschlossen sind, übertragen werden können. Grundsätzlich möglich ist auch ein Ausführungsbeispiel, bei dem einem erfindungsgemäßen Feldadapter mehrere erfindungsgemäße Frontadapter zugeordnet sind, so dass zum einen Signale drahtlos zwischen einer Feldkomponente und mehreren Steuerungseinrichtungen bzw. deren Eingabe-/Ausgabeeinheiten übertragen werden. Zum anderen kann eine erste Feldkomponente mit einer ersten Steuerungseinrichtung drahtlos Signale austauschen und eine zweite Feldkomponente mit zweiten Steuerungseinrichtung drahtlos Signale austauschen, wobei die erste und die zweite Feldkomponente an den selben als Feldadapter ausgebildeten Verbindungsadapter angeschlossen sind. Insbesondere für derartige Szenarien ist die bereits erwähnte Möglichkeit der Konfigurierbarkeit von Adressierungs- bzw. Identifizierungsinformationen mittels der Konfigurationseinheit eines Verbindungsadapters von großem Vorteil. Besonders erlaubt nämlich die Konfigurationseinheit die Zuweisung einer Adressierungs- bzw. Identifizierungsinformationen für den Verbindungsadapter an sich sowie für jede seiner Signalleitungen. Dadurch wird ein sehr flexibles Rangieren von Signalen zwischen Verbindungsadaptern und den angeschlossenen Signalleitungen möglich, indem Signalpfade unter Angabe der Adressierungs- bzw. Identifizierungsinformationen für Signalquelle und Signalziel konfigurierbar sind.

### Bezugszeichenliste

- 110: Steuerungseinrichtung
- 120: Ein-/Ausgabebaugruppe, Ein- und/oder Ausgabeeinheit
- 121: Kontaktstifte
- 130: Frontstecker
- 131: Kontaktbuchsen
- 132: Signalleitungen
- 133: Kabel mit Signalleitungen
- 140: Steckverbinder
- 141: Kontaktstifte
- 150: Feldübergabemodul, Feldkomponente
- 151: Klemmkontakten, Kontaktbuchsen
- 155: Feldgeräte, Aktoren, Feldkomponenten
- 155a: Motor
- 155b: Leuchtmelder
- 155c: Magnetventil
- 156: Feldgeräte, Sensoren, Feldkomponenten
- 156a: Kontaktschalter
- 156b: induktiver Näherungsschalter
- 156c: Lichtschranke
- 200a, 200b, 200c: Verbindungsadapter
- 201a, 201b, 201c: Signalschnittstelleneinheit
- 202a, 202b, 202c: Kommunikationseinheit
- 203a, 203b, 203c: Antenneneinheit
- 204a, 204b, 204c: Versorgungsspannungsschnittstelleneinheit
- 205a, 205b, 205c: Konfigurationseinheit

## Patentansprüche

1. Verbindungsadaptersystem der Steuerungstechnik zur Übertragung digitaler und/oder analoger Signale zwischen wenigstens einer Ein- und/oder Ausgabeeinheit (120) einer Steuerungseinrichtung (110) und wenigstens einer Feldkomponente (150, 155, 156), wobei wenigstens ein Verbindungsadapter (200a, 200b, 200c) zur drahtlosen Übertragung digitaler und/oder analoger Signale umfasst ist, welcher eine Signalschnittstelleneinheit (201a, 201b, 201c), eine Kommunikationseinheit (202a, 202b, 202c) und eine Antenneneinheit (203a, 203b, 203c) aufweist, wobei der Verbindungsadapter mittels der Signalschnittstelleneinheit mit der Ein- und/oder Ausgabeeinheit oder mit der Feldkomponente signalleitend kontaktierbar ist und ausgebildet ist, mit Hilfe der Kommunikationseinheit über die Signalschnittstelleneinheit eingehende Signale über die Antenneneinheit weiterzugeben und/oder über die Antenneneinheit eingehende Signale über die Signalschnittstelleneinheit weiterzugeben,
**dadurch gekennzeichnet, dass**
der Verbindungsadapter eine Konfigurationseinheit (205a, 205b, 205c) aufweist, mittels welcher eine Adressierungs- bzw. Identifizierungsinformation für den Verbindungsadapter konfigurierbar ist, und mittels welcher eine Adressierungs- bzw. Identifizierungsinformation für jede Signalleitung des Verbindungsadapters konfigurierbar ist.

2. Verbindungsadaptersystem nach Anspruch 1, wobei der Verbindungsadapter als Frontadapter (200a) und die Signalschnittstelleneinheit als Steckverbinder zur Kontaktierung der Ein- und/oder Ausgabeeinheit ausgebildet ist.

3. Verbindungsadaptersystem nach Anspruch 1, wobei der Verbindungsadapter als Feldadapter (200b, 200c) und die Signalschnittstelleneinheit als Steckverbinder oder als Anschlussblock für Signalleitungen zur Kontaktierung der wenigstens einen Feldkomponente ausgebildet ist.

4. Verbindungsadaptersystem, umfassend zwei Verbindungsadapter zur drahtlosen Übertragung digitaler und/oder analoger Signale, wobei der eine Verbindungsadapter gemäß Anspruch 2 und der andere Verbindungsadapter gemäß Anspruch 3 ausgebildet ist, und wobei über die Signalschnittstelleneinheit des einen Verbindungsadapters eingehende Signale über die Antenneneinheit des einen Verbindungsadapters drahtlos an die Antenneneinheit des anderen Schnittstellenadapters weitergegeben und über die Signalschnittstelleneinheit des anderen Verbindungsadapters ausgegeben werden können und/oder umgekehrt.

5. Verbindungsadaptersystem nach Anspruch 4, wobei zum Rangieren von Signalen zwischen den Verbindungsadaptern und deren Signalleitungen, mittels der Konfigurationseinheit Signalpfade unter Angabe der Adressierungs- bzw. Identifizierungsinformationen für Signalquelle und Signalziel konfigurierbar sind.

6. Verbindungsadaptersystem nach einem der vorstehenden Ansprüche, wobei der Verbindungsadapter eine Versorgungsspannungsschnittstelleneinheit (204a, 204b, 204c) aufweist, über welche der Verbindungsadapter eine Versorgungsspannung von der Ein- und/oder Ausgabeeinheit, von der Feldkomponente oder von einer separaten Spannungsquelle beziehen kann.

7. Verbindungsadaptersystem nach einem der vorstehenden Ansprüche, wobei mit der Konfigurationseinheit (205a, 205b, 205c) der Verbindungsadapter konfigurierbar hinsichtlich der Art der Signale, der Richtung der Signale und/oder der Rangierung der Signale ist.

8. Verbindungsadaptersystem nach Anspruch 1, wobei mittels der Konfigurationseinheit eine Adressierungsinformation für wenigstens eine Feldkomponente konfigurierbar ist.

## Claims

1. Connection adapter system of control technology for transmitting digital and/or analogue signals between at least one input and/or output unit (120) of a control device (110) and at least one field component (150, 155, 156), wherein at least one connection adapter (200a, 200b, 200c) is included for the wireless transmission of digital and/or analogue signals, which adapter comprises a signal interface unit (201a, 201b, 201c), a communications unit (202a, 202b, 202c) and an antenna unit (203a, 203b, 203c), wherein the connection adapter can be contacted in a signal-conductive manner by the input and/or output unit or by the field component by means of the signal interface unit and is configured to forward signals, arriving via the signal interface unit, using the communications unit via the antenna unit and/or to forward signals, arriving via the antenna unit, using the communications unit via the signal interface unit, **characterised in that** the connection adapter comprises a configuration unit (205a, 205b, 205c), by means of which addressing or identification information for the connection adapter can be configured, and by means of which addressing or identification information for each signal line of the connection adapter can be configured.

2. Connection adapter system as claimed in claim 1, wherein the connection adapter is configured as a front adapter (200a) and the signal interface unit is configured as a plug connector for contacting the input and/or output unit.

3. Connection adapter system as claimed in claim 1, wherein the connection adapter is configured as a field adapter (200b, 200c) and the signal interface unit is configured as a plug connector or as a terminal block for signal lines for contacting the at least one field component.

4. Connection adapter system, comprising two connection adapters for wirelessly transmitting digital and/or analogue signals, wherein one connection adapter is configured as claimed in claim 2 and the other connection adapter is configured as claimed in claim 3, and wherein signals arriving via the signal interface unit of the one connection adapter can be wirelessly forwarded via the antenna unit of the one connection adapter to the antenna unit of the other interface adapter and can be output via the signal interface unit of the other connection adapter, and/or vice-versa.

5. Connection adapter system as claimed in claim 4, wherein for switching signals between the connection adapters and the signal lines thereof, signal paths can be configured by means of the configuration unit, stating the addressing or identification information for signal source and signal destination.

6. Connection adapter system as claimed in any one of the preceding claims, wherein the connection adapter comprises a supply voltage interface unit (204a, 204b, 204c) via which the connection adapter can draw a supply voltage from the input and/or output unit, from the field component or from a separate voltage source.

7. Connection adapter system as claimed in any one of the preceding claims, wherein, by means of the configuration unit (205a, 205b, 205c), the connection adapter can be configured in terms of the signal type, the signal direction and/or the signal switching.

8. Connection adapter system as claimed in claim 1, wherein, by means of the configuration unit, addressing information for at least one field component can be configured.

## Revendications

1. Système d'adaptateur de raccordement pour la technique de commande destiné à la transmission de signaux numériques et/ou analogiques entre au moins une unité d'entrée et/ou de sortie (120) d'un dispositif de commande (110) et au moins un composant de terrain (150, 155, 156), où au moins un adaptateur de raccordement (200a, 200b, 200c) est compris pour la transmission sans fil de signaux numériques et/ou analogiques, lequel comporte une unité d'interface de signaux (201a, 201b, 201c), une unité de communication (202a, 202b, 202c) et une unité d'antenne (203a, 203b, 203c), où l'adaptateur de raccordement peut être mis en contact au moyen de l'unité d'interface de signaux avec l'unité d'entrée et/ou de sortie ou avec le composant de terrain de manière à acheminer les signaux, et est constitué pour, à l'aide de l'unité de communication, transmettre via l'unité d'antenne des signaux entrants via l'unité d'interface de signaux, et/ou pour transmettre via l'unité d'interface de signaux des signaux entrants via l'unité d'antenne, **caractérisé en ce que**
l'adaptateur de raccordement comporte une unité de configuration (205a, 205b, 205c) au moyen de laquelle une information d'adressage ou respectivement d'identification peut être configurée pour l'adaptateur de raccordement, et au moyen de laquelle une information d'adressage ou respectivement d'identification peut être configurée pour chaque ligne de signalisation de l'adaptateur de raccordement.

2. Système d'adaptateur de raccordement selon la revendication 1, où l'adaptateur de raccordement est constitué en tant qu'adaptateur frontal (200a), et l'unité d'interface de signaux en tant que connecteur pour la mise en contact de l'unité d'entrée et/ou de sortie.

3. Système d'adaptateur de raccordement selon la revendication 1, où l'adaptateur de raccordement est constitué en tant qu'adaptateur de terrain (200b, 200c), et l'unité d'interface de signaux est constituée en tant que connecteur ou en tant que bloc de connexion pour des lignes de signalisation pour la mise en contact de l'au moins un composant de terrain.

4. Système d'adaptateur de raccordement, comprenant deux adaptateurs de raccordement pour la transmission sans fil de signaux numériques et/ou analogiques, où un adaptateur de raccordement est constitué selon la revendication 2 et l'autre adaptateur de raccordement est constitué selon la revendication 3, et des signaux entrants via l'unité d'interface de signaux d'un adaptateur de raccordement peuvent être transmis sans fil à l'unité d'antenne de l'autre adaptateur d'interface via l'unité d'antenne d'un adaptateur de raccordement, et être délivrés via l'unité d'interface de signaux de l'autre adaptateur de raccordement et/ou inversement.

5. Système d'adaptateur de raccordement selon la revendication 4, où, pour le triage de signaux entre les adaptateurs de raccordement et leurs lignes de signalisation, au moyen de l'unité de configuration, des chemins de signaux peuvent être configurés avec indication des informations d'adressage ou respectivement d'identification pour la source des signaux et la cible des signaux.

6. Système d'adaptateur de raccordement selon l'une des revendications précédentes, où l'adaptateur de raccordement comporte une unité d'interface de tension d'alimentation (204a, 204b, 204c) via laquelle l'adaptateur de raccordement peut recevoir une tension d'alimentation en provenance de l'unité d'entrée et/ou de sortie, du composant de terrain ou d'une source de tension séparée.

7. Système d'adaptateur de raccordement selon l'une des revendications précédentes, où l'adaptateur de raccordement peut, avec l'unité de configuration (205a, 205b, 205c), être configuré en ce qui concerne le type de signaux, la direction des signaux et/ou le triage des signaux.

8. Système d'adaptateur de raccordement selon la revendication 1, où une information d'adressage pour au moins un composant de terrain peut être configurée au moyen de l'unité de configuration.
